# EUROPÄISCHE PATENTSCHRIFT

(11) **EP 1 800 187 B1**
(45) Veröffentlichungstag und Bekanntmachung des Hinweises auf die Patenterteilung: **02.04.2008**
(21) Anmeldenummer: 05805156.6
(22) Anmeldetag: 12.10.2005
(51) Int. Cl.: G03F 7/18

(54) **VERFAHREN UND VORRICHTUNG ZUR HERSTELLUNG VON FOTOPOLYMERISIERBAREN, ZYLINDRISCHEN, ENDLOS-NAHTLOSEN FLEXODRUCKELEMENTEN**
METHOD AND DEVICE FOR THE PRODUCTION OF PHOTOPOLYMERISABLE CYLINDRICAL JOINTLESS FLEXOGRAPHIC PRINTING ELEMENTS
PROCEDE ET DISPOSITIF PERMETTANT LA PRODUCTION D'ELEMENTS POUR IMPRESSION FLEXOGRAPHIQUE CYLINDRIQUES PHOTOPOLYMERISABLES SANS SOUDURE CONTINUE

(30) Priorität: 14.10.2004 DE 102004050277
(43) Veröffentlichungstag der Anmeldung: 27.06.2007
(73) Patentinhaber: Flint Group Germany GmbH, 70469 Stuttgart (DE)
(72) Erfinder: STEBANI, Uwe, 67592 Flörsheim-Dalsheim (DE); KRAUSS, Uwe, 67063 Ludwigshafen (DE); METZMANN, Udo, 67283 Obrigheim (DE)
(74) Vertreter: Huhn, Michael
(86) Internationale Anmeldenummer: PCT/EP2005/010959
(87) Internationale Veröffentlichungsnummer: WO 2006/042676

(56) Entgegenhaltungen:
- EP-A- 0 231 902
- EP-A- 1 170 343
- WO-A-20/04092841
- DE-A1- 2 722 896
- DE-A1- 2 911 908
- US-A- 4 758 500
- PATENT ABSTRACTS OF JAPAN Bd. 2002, Nr. 02, 2. April 2002 (2002-04-02) & JP 2001 290384 A (RICOH CO LTD), 19. Oktober 2001 (2001-10-19)

## Beschreibung

Die Erfindung betrifft ein Verfahren zur Herstellung von fotopolymerisierbaren zylindrischen, endlos-nahtlosen Flexodruckelementen durch Aufbringen einer Schicht aus einem fotopolymerisierbaren Material auf die äußeren Fläche eines Hohlzylinders und Verbinden der Kanten durch Kalandrieren. Die Erfindung betrifft weiterhin eine zur Ausführung des Verfahrens geeignete Vorrichtung.

Zylindrische Flexodruckformen sind prinzipiell bekannt. Bei einer zylindrischen Flexodruckform ist der Druckzylinder der Druckmaschine im gesamten Umfange mit einer Druckschicht bzw. einem Druckrelief versehen. Zylindrische Druckformen besitzen große Bedeutung für den Druck von Endlos-Mustern und werden beispielsweise zum Drucken von Tapeten, Dekorpapieren oder Geschenkpapieren verwendet.

Im Prinzip kann der eigentliche Druckzylinder der Druckmaschine selbst mit einer vollständig umhüllenden Druckschicht versehen werden. Diese Vorgehensweise hat jedoch den Nachteil, dass beim Wechsel der Druckform u.U. der gesamte Druckzylinder ausgetauscht werden muss. Dies ist äußerst aufwendig und dementsprechend teuer.

Üblich ist daher die Verwendung sogenannter Sleeves. Bei Sleeves handelt es sich um einen zylindrischen Hohlkörper -auch als Hülse bekannt-, der mit einer Druckschicht bzw. einem Druckrelief versehen worden ist. Die Sleeve-Technik ermöglicht einen sehr schnellen und einfachen Wechsel der Druckform. Der Innendurchmesser der Sleeves entspricht dem Außendurchmesser des Druckzylinders, so dass die Sleeves einfach über den Druckzylinder der Druckmaschine geschoben werden können. Das Auf- und Abschieben der Sleeves funktioniert nach dem Luftkissenprinzip: Für die Sleeve-Technologie ist die Druckmaschine mit einem speziellen Druckzylinder, einem sogenannten Luftzylinder, ausgestattet. Der Luftzylinder verfügt über einen Druckluftanschluss an der Stirnseite, mit dem Druckluft in das Innere des Zylinders geleitet werden kann. Von dort aus kann sie über an der Außenseite des Zylinders angeordnete Löcher wieder austreten. Zur Montage eines Sleeves wird Druckluft in den Luftzylinder eingeleitet und tritt an den Austrittslöchern wieder aus. Der Sleeve kann nun auf den Luftzylinder aufgeschoben werden, weil er sich unter dem Einfluss des Luftkissens geringfügig dehnt und das Luftkissen die Reibung deutlich vermindert. Wenn die Druckluftzufuhr beendet wird, geht die Dehnung zurück und der Sleeve sitzt auf der Oberfläche des Luftzylinders fest. Weitere Einzelheiten zur Sleeve-Technik sind beispielsweise offenbart in "Technik des Flexodrucks", S. 73 ff., Coating Verlag, St. Gallen, 1999.

Qualitativ hochwertige Runddruckformen können jedoch nicht hergestellt werden, indem man den Druckzylinder oder eine Hülse einfach mit einer bereits druckfertig verarbeiteten Flexodruckplatte vollständig umhüllt. An den zusammenstoßenden Enden der Druckplatte verbleibt nämlich ein feiner Spalt, welcher bei einem echten Endlos-Motiv immer auch druckende Bereiche der Platte durchschneidet. Dieser Spalt führt zu einer deutlich sichtbaren Linie im Druckbild. Um diese Linie zu vermeiden, dürfen sich an dieser Stelle nur nichtdruckende Vertiefungen befinden. Somit können nicht beliebige Muster gedruckt werden. Außerdem besteht bei dieser Technik die Gefahr, dass das in der Druckfarbe enthaltene Lösungsmittel in den Spalt eindringen und die Enden der Druckplatte vom Druckzylinder loslösen kann. Dies führt zu noch stärkeren Störungen im Druckbild. Auch bei einem Verkleben der Enden verbleiben noch deutlich sichtbare Spuren im Druckbild.

Zur Herstellung qualitativ hochwertiger Runddruckformen, ist es daher erforderlich, den Druckzylinder oder eine Hülse mittels geeigneter Techniken mit einer vollständig umhüllenden, reliefbildenden, fotopolymerisierbaren Schicht zu versehen. Erst in einem zweiten Schritt wird das zylindrische fotopolymerisierbare Flexodruckelement als solches zur fertigen Runddruckform verarbeitet. Geräte zur Verarbeitung zylindrischer Flexodruckelemente sind kommerziell erhältlich. Das Aufbringen einer endlos-nahtlosen, fotopolymerisierbaren Schicht kann beispielsweise durch Beschichten aus Lösung oder durch Ringextrusion erfolgen. Beide Techniken sind jedoch äußerst aufwändig und daher entsprechend teuer.

Generell kommt es beim Aufbringen der fotopolymerisierbaren Schicht auf höchste Präzision an: Moderne fotopolymerisierbare Flexodruckelemente erlauben die Herstellung von Flexodruckformen mit deutlich höherer Auflösung als dies früher der Fall war. Flexodruck dringt daher auch zunehmend in solche Bereiche vor, die früher anderen Druckverfahren vorbehalten waren. Bei höherer Auflösung werden aber auch Fehler in der druckenden Oberfläche der Flexodruckform schneller sichtbar. Dickenunterschiede in der reliefbildenden Schicht beeinträchtigen die Rundlaufgenauigkeit des Druckzylinders und damit die Druckqualität erheblich. Bei qualitativ hochwertigen Flexodruckformen sollte die Dickentoleranz üblicherweise nicht mehr als ± 10 µm betragen.

Falls die Dickentoleranz der fotopolymerisierbaren Schicht des Sleeves nicht ausreichend ist, so muss die Oberfläche des Sleeves nachgearbeitet werden. DE-A 31 25 564 und EP-A 469 375 offenbaren Verfahren zur Verbesserung der Druckqualität, bei denen man die Oberfläche des zylindrischen Flexodruckelementes zunächst abschleift, anschließend mit einem geeigneten Lösemittel glättet und verbliebene Unebenheiten gegebenenfalls mit Bindemittel oder dem Material der lichtempfindlichen Schicht auffüllt. Eine derartige Vorgehensweise ist naturgemäß äußerst aufwändig und langwierig. Sie sollte dementsprechend bei einem wirtschaftlichen Verfahren unbedingt vermieden werden.

Es sind auch Techniken bekannt, bei denen man den Druckzylinder oder die Hülse mit einer vorgefertigten, thermoplastisch verarbeitbaren Schicht aus fotopolymerisierbarem Material umwickelt und die zusammenstoßenden Kanten der fotopolymerisierbaren Schicht, auch Naht genannt, mittels geeigneter Techniken so gut wie möglich verschließt. So ist beispielsweise von DE 27 22 896 vorgeschlagen worden, ein handelsübliches, flächenförmiges, fotopolymerisierbares Flexodruckelement mitsamt der Trägerfolie auf einen Druckzylinder oder eine Hülse zu kleben, so dass die Schnittkanten aneinander stoßen. Bevorzugt erfolgt das Aufkleben mittels einer doppelseitigen Klebefolie. Die Schnittkanten sind gerade und werden anschließend unter Druck und Temperatur miteinander verschweißt. Das Verschweißen kann mit Hilfe einer beheizten Kalanderwalze erfolgen. Die Verwendung einer Platte mit Trägerfolie ist jedoch äußerst problematisch. Typische Trägerfolien weisen eine Dicke von 0,1 bis 0,25 mm auf. Sowie die Trägerfolie den Umfang nicht vollständig bedeckt und aufgrund eines kleinen Montage- oder Zuschnittfehlers auch nur minimal auseinander klafft, füllt sich der zwischen den Folienenden bestehende Leerraum beim Kalandrieren mit polymerem Material, und an der Oberfläche der fotopolymerisierbaren Schicht verbleibt ein Abdruck dieses Spaltes, der zu sichtbaren Störungen im Druck führt. Daher muss auch ein derartiges Flexodruckelement im Regelfalle nachgeschliffen und geglättet werden.

DE-A 29 11 908 offenbart ein Verfahren, bei dem ein Druckzylinder mit einer lichtempfindlichen Harzfolie umwickelt wird, ohne dass ein wesentlicher Abstand oder eine wesentliche Überlappung zwischen den Plattenenden vorhanden ist. Bevorzugt erfolgt das Aufbringen auf den Zylinder unter Verwendung einer doppelseitigen Klebefolie. Die Naht wird verschlossen, indem man den Druckzylinder mit einer Kalandrierwalze unter Drehen in Kontakt bringt, und die Schnittkanten durch Schmelzen miteinander verbindet. Zum Aufheizen schlägt DE-A 29 11 908 vor, entweder die Kalanderwalze von innen zu beheizen, oder aber die lichtempfindliche Harzfolie mittels eines IR-Strahlers von außen zu beheizen. Zur Temperatur führt die Schrift aus, dass das lichtempfindliche Material zwar erweichen soll, bevorzugt aber nicht fließen soll.

Unsere eigene, noch unveröffentlichte Anmeldung DE 103 18 042.7 offenbart ein Verfahren zum Herstellen von zylindrischen Flexodruckelementen, bei dem man eine fotopolymerisierbare Schicht auf eine Hülse aufbringt und die Naht mittels einer Kalanderwalze unter Erwärmen verschließt. Bevorzugt wird hierzu die gesamte Kalanderwalze von innen beheizt. Das Erwärmen kann zusätzlich durch IR-Strahler ergänzt werden. Die zu verbindenden Kanten werden mittels Gehrungsschnitten zurechtgeschnitten.

Bei allen zitierten Schriften wird die fotopolymerisierbare Schicht in ihrer Gesamtheit erwärmt. Hierdurch erwärmt sich mit zunehmender Kalandrierdauer aber auch die Hülse bzw. der Druckzylinder und somit auch das doppelseitige Klebeband, welches zum Aufkleben der fotopolymerisierbaren Schicht verwendet wird. Die Klebekraft der Klebebänder nimmt aber mit zunehmender Temperatur ab, so dass die fotopolymerisierbare Schicht nur noch mit geringerer Kraft auf der Hülse fixiert ist und verrutschen kann. Hierdurch wird eine Oberfläche geringerer Glätte erhalten, so dass die Oberfläche wieder nachgearbeitet werden muss. Weiterhin kann sich bei einer zu hohen Temperatur die Schicht auch in unerwünschter Weise plastisch verformen.

Neben dem Problem eines qualitativ hochwertigen Nahtverschlusses und dem Erhalt einer möglichst konstanten Schichtdicke stellt die so genannte Rückseitenvorbelichtung ein weiteres Problem der Sleeve-Technologie dar. Flexodruckelemente werden üblicherweise vor der eigentlichen Hauptbelichtung von der Rückseite durch die Trägerfolie hindurch für eine kurze Zeitspanne vorbelichtet. Hierdurch wird der Reliefuntergrund vorpolymerisiert und eine bessere Versockelung, insbesondere feiner Reliefelemente, im Reliefuntergrund erreicht.

Bei Sleeves ist eine Rückseitenvorbelichtung im Regelfalle nicht möglich, da die üblichen Hülsenmaterialien, wie beispielsweise glasfaserverstärkter Kunststoff oder Metall, nicht transparent für UV-Strahlung sind. Von EP-A 766 142 ist die Verwendung transparenter Hülsen vorgeschlagen worden, insbesondere Hülsen aus Polyestern wie PET oder PEN in einer Dicke von 0,25 mm bis zu 5 cm. Diese sind jedoch teuer. Des Weiteren sind spezielle Belichtungsgeräte zum gleichmäßigen Belichten der Hülse von Innen her erforderlich. Außerdem sieht sich der Fachmann bei transparenten Hülsen einer typischen Scherensituation gegenüber. Die mechanische Stabilität der Hülse nimmt mit zunehmender Dicke der Hülse zu, während die Durchlässigkeit der Hülse für aktinisches Licht mit zunehmender Dicke der Hülse abnimmt. Das Problem einer effizienten Rückseitenbelichtung von Sleeves ohne Verminderung der Stabilität der Hülse ist nach wie vor ungelöst.

Es ist prinzipiell möglich, eine feste fotopolymerisierbare Schicht bereits vor dem Aufbringen auf die Hülse rückseitig vorzubelichten. Derartig vorbelichtete Schichten lassen sich aber bislang nicht so zufriedenstellend verschweißen, wie es zu Herstellung qualitativ hochwertiger endlos-nahtloser Druckformen zweckmäßig und notwendig wäre, weil sich bekanntermaßen nur die unvernetzte, nicht aber die belichtete, vernetzte Polymerschicht einwandfrei verschweißen lässt. Weiterhin geht häufig der Effekt der Vorbelichtung durch das Verschweißen der Schichtenden bei erhöhten Temperaturen wieder verloren. Dadurch sind insbesondere feine Reliefpunkte schlecht versockelt.

Von DE-A 37 04 694 ist zur Lösung dieses Problems daher vorgeschlagen worden, auf eine Hülse zunächst eine erste Schicht von Fotopolymermaterial aufzubringen, die Naht zu verschweißen, und die fotopolymere Schicht danach von der Vorderseite her durch Belichten zu polymerisieren. In einem zweiten Verfahrensschritt wird eine fotopolymere Schicht auf die erste, bereits vernetzte Schicht aufgebracht und auch deren Naht verschweißt. Diese zweistufige Verfahren ist jedoch sehr umständlich und teuer.

Aufgabe der Erfindung war es, ein verbessertes Verfahren zur Herstellung von zylindrischen, endlos-nahtlosen, fotopolymerisierbaren Flexodruckelementen bereitzustellen, welches einen besseren Verschluss der Naht als bei den bekannten Technologien sowie eine sehr gute Rundlaufgenauigkeit gewährleistet. Rückseitenvorbelichtung sollte auf einfache Art und Weise möglich sein, ohne einen zufriedenstellenden Verschluss der Naht zu beeinträchtigen. Weiterhin sollte ein Nachbearbeiten des Flexodruckelementes durch Schleifen und Glätten vermieden werden, und das Verfahren sollte möglichst schnell durchgeführt werden können.

Dementsprechend wurde ein Verfahren zur Herstellung von fotopolymerisierbaren zylindrischen, endlos-nahtlosen Flexodruckelementen gefunden, bei dem man als Ausgangsmaterial einen Schichtenverbund umfassend mindestens
- eine Schicht aus einem fotopolymerisierbaren Material mindestens umfassend ein elastomeres Bindemittel, ethylenisch ungesättigte Monomere und einen Fotoinitiator, sowie
- eine von der Schicht abziehbare Trägerfolie,
einsetzt, und wobei das Verfahren die folgenden Schritte umfasst:
(a) Zurechtschneiden der zu verbindenden Kanten des Schichtenverbundes mittels Gehrungsschnitten,
(b) Aufschieben und Arretieren eines Hohlzylinders auf einen drehbar gelagerten Trägerzylinder,
(c) Aufbringen einer Haftschicht auf die äußere Fläche des Hohlzylinders,
(d) Aufbringen des zurechtgeschnittenen Schichtenverbundes mit der von der abziehbaren Trägerfolie abgewandten Seite auf den mit der Haftschicht versehenen Hohlzylinder, wobei die mit dem Gehrungsschnitt versehenen Enden im wesentlichen aufeinander liegen, aber nicht überlappen,
(e) Abziehen der Trägerfolie von der Schicht aus fotopolymerisierbarem Material,
(f) Verbinden der Schnittkanten, indem man die Oberfläche der fotopolymerisierbaren Schicht auf dem Hohlzylinder unter Erwärmen mit einer sich drehenden Kalanderwalze in Kontakt bringt, bis die Schnittkanten miteinander verbunden sind,
(g) Abziehen des bearbeiteten Hohlzylinders vom Trägerzylinder,
wobei man zum Erwärmen in Schritt (f) eine punktuell wirkende Wärmequelle einsetzt, welche die fotopolymerisierbare Schicht von der Oberseite her erwärmt, und wobei man die Wärmequelle axial zum Hohlzylinder über die gesamte Breite der fotopolymerisierbaren Schicht verschiebt.

In einer bevorzugten Ausführungsform der Erfindung handelt es sich bei der Haftschicht um ein doppelseitiges Klebeband.

Weiterhin wurde eine zur Ausführung des Verfahrens besonders geeignete Apparatur gefunden.

Durch das erfindungsgemäße Verfahren lassen sich auf überraschend einfache Art und Weise zylindrische, endlos-nahtlose fotopolymerisierbare Flexodruckelemente in hoher Qualität erhalten. Die erfindungsgemäß zur Herstellung der Sleeves verwendete Apparatur führt zu einer nur geringen Temperaturbelastung der fotopolymerisierbaren schicht und dementsprechend zu einer hohen Präzision der Schicht. Ein Nacharbeiten des erhaltenen Flexodruckelementes durch aufwendige Schleif- und Glättvorgänge ist überflüssig. Dennoch wird ein sehr guter Nahtverschluss erreicht, wie durch Zugdehnungsmessungen gezeigt werden konnte. Die Rückseitenvorbelichtung des Flexodruckelementes ist möglich, auch ohne dass eine transparente Hülse eingesetzt werden muss.

Verzeichnis der Abbildungen:
- Fig. 1:: Querschnitt durch ein zum Kalandrieren vorbereitetes Flexodruckelement, bei dem die zu verbindenden Kanten mittels eines Gehrungsschnittes zurechtgeschnitten und übereinander gelegt sind (schematisch).
- Fig. 2:: Aufsicht auf eine erfindungsgemäße Apparatur (schematisch).

Zu der Erfindung ist im Einzelnen das Folgende auszuführen:

Als Ausgangsmaterial für das Verfahren wird ein Schichtenverbund eingesetzt, welcher mindestens eine elastomere Schicht aus einem fotopolymerisierbaren Material sowie eine von der Schicht abziehbare Trägerfolie umfasst. Der Schichtenverbund kann optional auch noch eine weitere abziehbare Folie auf der von der Trägerfolie abgewandten Seite der Schicht umfassen. Sowohl die Trägerfolie als auch die zweite Folie können zur besseren Abziehbarkeit auf geeignete Weise behandelt sein, beispielsweise durch Silikonisierung oder durch Beschichten mit einer geeigneten Entklebeschicht. Derartige Entklebeschichten sind auf dem Gebiet der Flexodruckplattentechnik auch als "releaselayer" bekannt und können beispielsweise aus Polyamiden oder Polyvinylalkoholen bestehen.
Bei dem fotopolymerisierbaren Material handelt es sich um übliche fotopolymerisierbare Materialien, die für den Einsatz in Flexodruckelementen typisch sind, und mindestens ein elastomeres Bindemittel, ethylenisch ungesättigte Monomere sowie einen Fotoinitiator oder ein Fotoinitiatorsystem umfassen. Geeignete Gemische sind beispielsweise von EP-A 084 851 offenbart.

Bei dem elastomeren Bindemittel kann es sich um ein einzelnes Bindemittel oder um ein Gemisch verschiedener Bindemittel handeln. Beispiele geeigneter Bindemittel sind die bekannten Vinylaromat/Dien-Copolymere bzw. Blockcopolymere, wie beispielsweise übliche Blockcopolymere vom Styrol-Butadien- oder Styrol-Isopren-Typ, weiterhin Dien/Acrylnitril-Copolymere, Ethylen/Propylen/Dien-Copolymere oder Dien/Acrylat/Acrylsäure-Copolymere. Selbstverständlich können auch Gemische verschiedener Bindemittel eingesetzt werden.

Für das erfindungsgemäße Verfahren werden bevorzugt solche Bindemittel oder Bindemittelmischungen eingesetzt, die eine möglichst geringe Klebrigkeit aufweisen. Besonders bewährt für das erfindungsgemäße Verfahren haben sich thermoplastischelastomere Bindemittel vom Styrol-Butadien-Typ. Es kann sich dabei um Zweiblockcopolymere, Dreiblockcopolymere oder Multiblockcopolymere handeln, bei denen alternierend jeweils mehrere Styrol- und Butadienblöcke aufeinander folgen. Es kann sich sowohl um lineare, verzweigte oder auch sternförmige Blockcopolymere handeln. Bevorzugt handelt es sich bei den erfindungsgemäß eingesetzten Blockcopolymeren um Styrol-Butadien-Styrol-Dreiblockcopolymere, wobei zu berücksichtigen ist, dass handelsübliche Dreiblockcopolymere üblicherweise einen gewissen Anteil von Zweiblockcopolymeren aufweisen. Derartige Blockcopolymere sind kommerziell erhältlich, beispielsweise unter dem Namen Kraton^{®}. Selbstverständlich können auch Gemische verschiedener SBS-Blockcopolymere eingesetzt werden. Der Fachmann trifft unter den verschiedenen Typen je nach den gewünschten Eigenschaften der Schicht eine geeignete Auswahl.

Bevorzugt werden Styrol-Butadien-Blockcopolymere eingesetzt, die ein mittleres Molekulargewicht M_{w} (Gewichtsmittel) von 100 000 bis 250 000 g/mol aufweisen. Der bevorzugte Styrol-Gehalt derartiger Styrol-Butadien-Blockcopolymeren beträgt 20 bis 40 Gew. % bezüglich des Bindemittels.

Bei den ethylenisch ungesättigten Monomeren handelt es sich insbesondere um Acrylate oder Methacrylate von mono- oder polyfunktionellen Alkoholen, Acryl- oder Methacrylamiden, Vinylethern oder Vinylestern. Beispiele umfassen Butyl(meth)acrylat, 2-Ethylhexyl(meth)acrylat, Butandioldi(meth)acrylat oder Hexandioldi(meth)acrylat.

Selbstverständlich können auch Gemische verschiedener Monomerer eingesetzt werden. Als Initiatoren für die Photopolymerisation sind aromatische Verbindungen, beispielsweise Ketoverbindungen wie Benzoin oder Benzoinderivate geeignet.

Die photopolymerisierbaren Gemische können ferner übliche Hilfsstoffe wie beispielsweise Inhibitoren für die thermisch initiierte Polymerisation, Weichmacher, Farbstoffe, Pigmente, fotochrome Zusätze, Antioxidantien, Antiozonantien oder Extrusionshilfsmittel umfassen.

Art und Menge der Komponenten der fotopolymerisierbaren Schicht werden vom Fachmann je nach den gewünschten Eigenschaften und dem gewünschten Verwendungszweck des Flexodruckelementes bestimmt.

Soll das Flexodruckelement mittels Laser-Direktgravur zu einer Flexodruckform verarbeitet werden, so kann der Fachmann vorteilhaft zur Laser-Direktgravur besonders angepasste Formulierungen für die Schicht wählen. Derartige Formulierungen sind beispielsweise von WO 02/76739, WO 02/83418 oder den noch unveröffentlichten Schriften mit den Aktenzeichen DE 101 57 769.9, DE 102 27 188.7, DE 102 27 189.5 offenbart, auf die wir an dieser Stelle ausdrücklich verweisen.

Die Schichtenverbunde lassen sich in prinzipiell bekannter Art und Weise herstellen, indem man alle Komponenten der fotopolymerisierbaren Schicht in einem geeigneten Lösemittel löst, auf die abziehbare Trägerfolie aufgießt und das Lösemittel verdampfen lässt. Bevorzugt wird der Schichtenverbund in prinzipiell bekannter Weise durch Schmelzextrusion und Kalandrierung zwischen die abziehbare Trägerfolie und eine weitere abziehbare Folie hergestellt. Derartige fotopolymerisierbare Schichtenverbunde sind auch kommerziell erhältlich, beispielsweise als nyloflex^{®} SL (BASF Drucksysteme GmbH). Es können auch Schichtenverbunde eingesetzt werden, die zwei oder mehrere fotopolymerisierbare Schichten aufweisen. Die Dicke des Schichtenverbundes beträgt in der Regel 0,4 bis 7 mm, bevorzugt 0,5 bis 4 mm und besonders bevorzugt 0,7 bis 2,5 mm.

Die fotopolymerisierbare Schicht kann optional vor dem Aufbringen auf den Hohlzylinder in Verfahrensschritt (d) mit aktinischem Licht von der Rückseite her vorbelichtet werden. Die Vorbelichtung wird auf der der Trägerfolie abgewandten Seite der fotopolymerisierbaren Schicht vorgenommen, also der späteren Unterseite der Schicht. Bei der Vorbelichtung kann direkt die Oberfläche der fotopolymerisierbaren Schicht bestrahlt werden. Falls eine zweite abziehbare Folie vorhanden ist, kann diese zweite Folie entweder abgezogen werden, oder es wird bevorzugt durch die Folie hindurch belichtet, vorausgesetzt die Folie ist ausreichend transparent.

Die Durchführung der Vorbelichtung wird in Analogie zu der üblichen Rückseitenvorbelichtung von Flexodruckplatten vorgenommen. Die Vorbelichtungszeit beträgt in aller Regel nur wenige Sekunden bis zu etwa einer Minute und wird vom Fachmann je nach den gewünschten Eigenschaften der Schicht festgelegt. Selbstverständlich hängt die Vorbelichtungszeit auch von der Intensität des aktinischen Lichtes ab. Es wird nur der Schichtuntergrund anpolymerisiert, aber keinesfalls die gesamte Schicht durch polymerisiert.

Der Fachmann bestimmt je nach dem gewünschten Verwendungszweck des Flexodruckelementes, ob ein Vorbelichtungsschritt vorgenommen wird oder nicht. Falls die Weiterverarbeitung des Flexodruckelementes zu Flexodruckformen auf konventionellem Wege durch bildmäßiges Belichten und Entwickeln mittels eines Lösemittels vorgesehen ist, so ist eine Vorbelichtung in aller Regel empfehlenswert, wenn auch nicht immer unbedingt erforderlich. Falls die Weiterverarbeitung mittels Laser-Direktgravur vorgesehen ist, so ist ein Vorbelichtungsschritt im Regelfalle überflüssig.

Die Vorbelichtung sollte im Regelfalle vor dem Zurechtschneiden des Schichtenverbundes in Schritt (a) erfolgen, um eine problemlose Verbindung der Schnittkanten zu gewährleisten. Falls eine transparente Hülse eingesetzt wird, kann die Vorbelichtung selbstverständlich auch erst nach dem Aufbringen der Schicht auf die Hülse von der Innenseite der Hülse aus erfolgen.

In Verfahrensschritt (a) werden die zu verbindenden Kanten des bereitgestellten Schichtenverbundes zurechtgeschnitten. Erfindungsgemäß wird das Zurechtschneiden mittels Gehrungsschnitten vorgenommen, also mittels Schnitten, die nicht senkrecht durch den Schichtenverbund geführt werden, sondern schräg. Die Länge des Schichtenverbundes wird durch die Schnitte so bemessen, dass der Umfang der Hülse vollständig umhüllt werden kann und die mit den Gehrungsschnitten versehenen Enden im Wesentlichen aufeinander liegen, aber nicht überlappen.

Im Regelfalle beträgt der Gehrungswinkel 10° bis 80°, bevorzugt 20° bis 70°, besonders bevorzugt 30° bis 60° und beispielsweise 50°. Die genannten Winkel beziehen sich jeweils auf die Senkrechte durch die Schicht. Beide Schnittkanten können mit dem gleichen Gehrungswinkel geschnitten werden. Kleinere Abweichungen des Gehrungswinkels beider Schnittkanten voneinander sind aber auch möglich, ohne die ordnungsgemäße Verbindung der Schnittkanten zu beeinträchtigen. Vielmehr kann durch leicht unterschiedliche Gehrungswinkel besonders elegant berücksichtigt werden, dass der Innendurchmesser der fotopolymerisierbaren Schicht etwas kleiner ist als der Außendurchmesser. Die Gehrungswinkel werden so berechnet, dass nach dem Schneiden die spätere Innenseite der fotopolymerisierbaren Schicht genau um das richtige Maß kürzer ist als die spätere Außenseite. Die Winkel sollten aber in aller Regel nicht mehr als ca. 20°, bevorzugt nicht mehr als 10° voneinander abweichen.

Selbstverständlich können auch die seitlichen Kanten zurechtgeschnitten werden, sofern die Breite des Rohmaterials nicht schon passend ist. Die seitlichen Kanten werden bevorzugt gerade geschnitten. Die Breite des Schichtenverbundes kann naturgemäß die maximale Hülsenlänge nicht überschreiten. Im Regelfalle wird nicht die gesamte Länge der Hülse mit dem fotopolymeren Material bedeckt, sondern es wird an den Enden jeweils ein schmaler Streifen unbedeckt gelassen. Dies wird vom Fachmann je nach den gewünschten Eigenschaften des Flexodruckelementes festgelegt.

Bei den als Träger verwendeten Hohlzylindern handelt es sich um übliche Hohlzylinder für den Flexodruck, bevorzugt um solche, die zur Montage auf Luftzylinder geeignet sind, d.h. sich unter dem Einfluss von Druckluft geringfügig dehnen können. Derartige Hohlzylinder werden auch als Hülsen oder manchmal auch als Sleeves, Basis-Sleeves oder dergleichen bezeichnet. Für die Zwecke dieser Erfindung sollen im Folgenden die als Träger verwendeten Hohlzylinder als solche als Hülse beizeichnet werden, während der Begriff "Sleeve" für das Flexodruckelelement als Ganzes, also inklusive der fotopolymerisierbaren Schicht, Klebeschicht und eventueller weiterer Schichten reserviert sein soll.

Geeignet zur Ausführung des erfindungsgemäßen Verfahrens sind insbesondere Hülsen aus polymeren Materialien, wie beispielsweise Polyurethanen, Polyestern oder Polyamiden. Die polymeren Materialien können auch verstärkt sein, beispielsweise mit Glasfasergeweben. Es kann sich auch um mehrschichtige Materialien handeln. Weiterhin können selbstverständlich Hülsen aus Metallen, beispielsweise solche aus Nickel eingesetzt werden.

Dicke, Durchmesser und Länge der Hülse werden vom Fachmann je nach den gewünschten Eigenschaften und dem gewünschten Anwendungszweck bestimmt. Durch Variation der Wandstärke bei konstantem Innendurchmesser (notwendig für die Montage auf bestimmten Druckzylinder) kann der Außenumfang der Hülse und damit die sogenannte Drucklänge bestimmt werden. Unter "Drucklänge" versteht der Fachmann die Länge des gedruckten Motivs bei einer Umdrehung des Druckzylinders. Geeignete Hülsen mit Wandstärken von 1 bis 100 mm sind kommerziell erhältlich, beispielsweise als Blue Light der Fa. Rotec oder auch von Fa. Polywest oder Fa. Rossini. Es kann sich sowohl um kompressible Hülsen wie um so genannte hard-coated Hülsen handeln.

Die verwendeten Hülsen werden zur Ausführung des erfindungsgemäßen Verfahrens in Verfahrensschritt (b) auf einen drehbar gelagerten Trägerzylinder aufgeschoben und arretiert, so dass der Hohlzylinder mit dem Trägerzylinder fest verbunden ist und keine Bewegung relativ zueinander möglich ist. Der Trägerzylinder bietet einen festen Halt für den nachfolgenden Kalandrierprozess. Das Arretieren kann beispielsweise durch Festklemmen oder Festschrauben erfolgen. Bevorzugt handelt es sich bei dem Trägerzylinder aber um einen Luftzylinder, dessen Funktionsweise den in Druckmaschinen verwendeten Luftzylindern entspricht. Die Montage der Hülse erfolgt dann sehr elegant, indem man den Luftzylinder zum Aufschieben an Druckluft anschließt, und somit das Aufschieben der Hülse ermöglicht. Nach dem Abschalten der Druckluft ist die Hülse fest auf dem Luftzylinder arretiert. Der Umfang des Luftzylinders kann auch in prinzipiell bekannter Art und Weise durch Verwendung von so genannten Adapter- oder Bridge-Sleeves (eigentlich -Hülsen) vergrößert werden. Dadurch können Hülsen mit größerem Innendurchmesser eingesetzt werden, und somit sind bei gleichem Luftzylinder auch größere Drucklängen erreichbar. Auch Adapter-Sleeves sind kommerziell erhältlich (z.B. Fa. Rotec).

In Verfahrensschritt (c) wird eine Haftschicht auf die äußere Fläche des Hohlzylinders aufgebracht. Die Haftschicht soll auch noch bei erhöhten Temperaturen, wie sie während des Kalandriervorganges herrschen, eine gute Haftung vermitteln. Sie soll insbesondere eine sehr gute Scherfestigkeit vermitteln, damit die fotopolymerisierbare Schicht während des Kalandriervorganges nicht auf der Oberfläche des Hohlzylinders verrutscht. Bei der Haftschicht kann es sich um einen geeigneten Haftlack handeln, der auf die Oberfläche des Hohlzylinders aufgetragen wird.

Bevorzugt handelt es sich aber bei der Haftschicht um eine doppelseitige Klebefolie. Doppelseitige Klebefolien zur Montage von Druckplatten sind bekannt und in verschiedenen Ausführungsformen erhältlich. Insbesondere kann es sich bei den Klebefolien um Schaumklebefolien handeln, welche zusätzlich eine dämpfende Schaumstoffschicht aufweisen.

Bei Schaumklebebändern kann es sich beispielsweise um ein Klebeband auf Basis von offenzelligem oder geschlossenzelligem PU-Schaumstoff handeln. Es kann sich aber auch um andere Materialien handeln. Aufgrund der geringen Temperaturbelastung beim erfindungsgemäßen Verfahren lassen sich mit besonderem Vorteil auch PE-Schaumstoffe einsetzen.

Die Klebefolie sollte eine möglichst hohe statische Scherfestigkeit aufweisen. Die statische Scherfestigkeit wird in Anlehnung an DIN EN 1943 bestimmt. Bei diesem Test wird ein Stück der Klebfolie mit genau definierten Abmessungen auf eine polierte Metallplatte geklebt und daran horizontal mit einer genau definierten Kraft gezogen. Gemessen wird die Zeit, bis sich das Band 2,5 mm auf dem Untergrund bewegt hat. Der Test kann bei erhöhten Temperaturen durchgeführt werden. Die Einzelheiten zum Test sind im Beispielteil zusammengestellt.

Bevorzugt wird zur Ausführung der vorliegenden Erfindung eine Klebefolie eingesetzt, welche bei 70°C eine statische Scherfestigkeit von mindestens 3 h, bevorzugt mindestens 10 h und besonders bevorzugt mindestens 20 h aufweist.

Das doppelseitige Klebeband sollte so auf die Oberfläche des Hohlzylinders aufgeklebt werden, dass die Schnittkanten genau aneinander stoßen und im Wesentlichen weder ein Zwischenraum zwischen den Enden verbleibt, noch die Enden überlappen. Es ist ganz besonders vorteilhaft, auch das Klebeband mittels eines Gehrungsschnittes zurechtzuschneiden. Bewährt haben sich Winkel von 5 bis 20°, bevorzugt 5 bis 10°. Hierdurch werden ganz besonders gut aufeinanderliegende Enden erhalten. Um gutes Aufeinanderliegen der Schnittkanten zu gewährleisten, beginnt man das Aufkleben der Klebefolie zweckmäßigerweise mit der Schnittkante, deren Unterseite länger ist als die Oberseite. Nach dem vollständigen Umwickeln liegt schließlich die zweite Schnittkante bei der die Oberseite länger ist als die Unterseite, auf der ersten Schnittkante präzise auf.

In Verfahrensschritt (d) wird die fotopolymerisierbare Schicht auf den mit der Haftschicht versehenen Hohlzylinder aufgebracht. Hierzu wird der zurechtgeschnittene Schichtenverbund mit der von der temporären Trägerfolie abgewandten Seite auf den mit der Haftschicht versehenen Hohlzylinder aufgebracht. Falls eine zweite abziehbare Folie vorhanden ist, wird diese -inklusive einer eventuell vorhandenen Entklebeschicht- vor dem Aufbringen selbstverständlich entfernt werden. Das Aufbringen sollte blasenfrei erfolgen und wird so vorgenommen, dass die mit dem Gehrungsschnitt versehenen Enden im Wesentlichen aufeinander liegen, aber nicht überlappen.

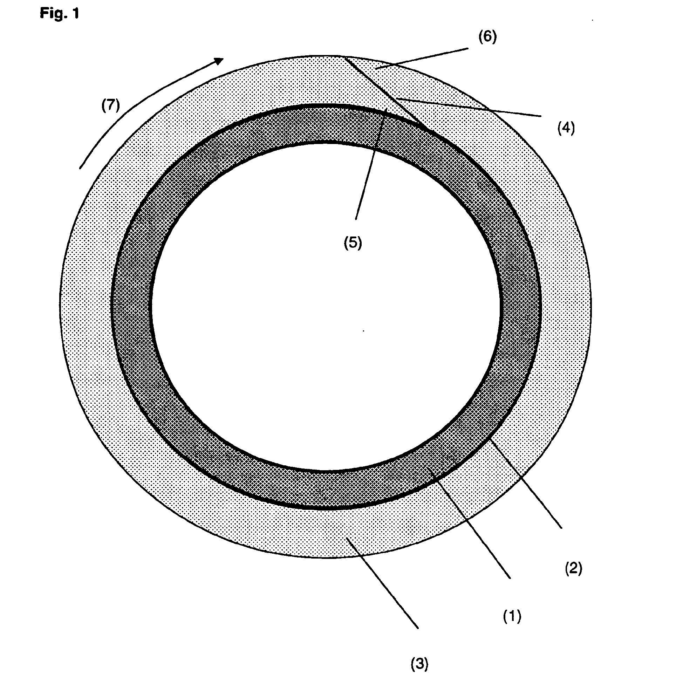

Fig. 1 zeigt schematisch einen Querschnitt durch ein zum Kalandrieren vorbereitetes Flexodruckelement, bei dem die zu verbindenden Kanten jeweils mittels eines Gehrungsschnittes zurechtgeschnitten und übereinander gelegt sind: Auf die Hülse (1) sind ein Klebeband (2) sowie die fotopolymerisierbare Schicht (3) aufgebracht. Die zu verbindenden Kanten sind mittels Gehrungsschnitten (4) zurechtgeschnitten und übereinander gelegt. Mit dem Pfeil (7) ist die bevorzugte Drehrichtung des Flexodruckelementes beim Kalandrieren angegeben. Der Luftzylinder ist in Fig. 1 der besseren Übersicht halber weggelassen worden.

Um gutes Aufeinanderliegen der Schnittkanten zu gewährleisten, beginnt man das Aufbringen des Schichtelementes zweckmäßigerweise daher mit der Schnittkante, deren Unterseite länger ist als die Oberseite (Fig.1, (5)). Nach dem vollständigen Umwickeln liegt schließlich die zweite Schnittkante (6), bei der die Oberseite länger ist als die Unterseite, auf der ersten Schnittkante auf.

Nach dem Aufbringen des Schichtelementes wird die Trägerfolie inklusive einer eventuell vorhandenen Entklebeschicht von der Schicht aus fotopolymerem Material abgezogen (Verfahrensschritt (e)).

In Verfahrensschritt (f) werden die Schnittkanten verbunden. Zum Verbinden der Schnittkanten wird die Oberfläche der fotopolymerisierbaren Schicht auf dem Hohlzylinder mit einer sich drehenden Kalanderwalze in Kontakt gebracht, bis die Schnittkanten miteinander verbunden sind. Der Trägerzylinder und die Kalanderwalze drehen sich gegeneinander. Der notwendige Kalanderdruck wird vom Fachmann je nach der Art der fotopolymerisierbaren Schicht durch das Einstellen des Abstandes zwischen dem Trägerzylinder und der Kalanderwalze bestimmt.

Die fotopolymerisierbare Schicht wird zum Verbinden von der Oberfläche her erwärmt. Erfindungsgemäß wird hierzu eine nur punktuell wirkende Wärmequelle eingesetzt. Der Begriff "punktuell" im Sinne dieser Erfindung bedeutet, dass die Wärmequelle nicht auf die gesamte Breite der fotopolymerisierbaren Schicht auf einmal einwirkt, sondern dass die Wärmequelle nur auf einen begrenzten Abschnitt der fotopolymerisierbaren Schicht einwirken kann.

Die Größe des erwärmbaren Abschnittes richtet sich nach den konkreten Gegebenheiten, wie beispielsweise der Art der Wärmequelle sowie dem Durchmesser und der Breite der Hülse. Bezogen auf die Breite der Hülse ist im Regelfalle maximal ein Abschnitt von 20 % davon gleichzeitig erwärmbar, bevorzugt maximal 10%.

Die Wärmequelle erwärmt die fotopolymerisierbare Schicht punktuell von der Oberfläche her. Unter dem Einfluss der erfindungsgemäß eingesetzten Wärmequelle wird die fotopolymerisierbare Schicht nicht gleichmäßig im gesamten Volumen erwärmt, sondern die Wärmequelle erwärmt hierbei im Wesentlichen nur den obersten Abschnitt der fotopolymerisierbaren Schicht. Mit anderen Worten gesagt weist die fotopolymerisierbare Schicht einen Temperaturgradienten auf. Die Temperatur der Schicht ist an oder nahe der Oberfläche am höchsten und nimmt dann mit zunehmender Entfernung von der Oberfläche ab. Dies bedeutet nicht, dass die Schicht an der Unterseite Raumtemperatur aufweisen muss, sie ist aber niedriger als an der Oberfläche.

Besonders geeignet zur Ausführung der Erfindung sind warme Gasströme, die beispielsweise durch Heißluftföns erzeugt werden können. Hierdurch wird vor allem die Oberfläche der fotopolymerisierbaren Schicht erhitzt. Von dort aus kann sich die Wärme nur durch Dissipation verbreiten.

Selbstverständlich sind aber auch andere Wärmequellen möglich, solange sich hierdurch nur gezielt die Oberfläche beheizen lässt. Denkbar wären beispielsweise IR-Strahler, sofern man diese ausschließlich auf die Schichtoberfläche fokussiert.

Erfindungsgemäß wird die Wärmequelle zum Verbinden axial zum mit der fotopolymerisierbaren Schicht belegten Hohlzylinder über die gesamte Breite der Schicht verschoben. Die Kombination der axialen Bewegung der Wärmequelle mit der Drehbewegung der Hülse führt dazu, dass sich der Fokus der Wärmequelle in Form einer Schraubenbewegung über die Oberfläche der Hülse fortbewegt. Auf diese Art und Weise wird nach und nach die gesamte Oberfläche der fotopolymerisierbaren Schicht von der Wärmequelle einmal erhitzt.

Die zum Verbinden der Naht erforderliche Temperatur richtet sich nach der Art der fotopolymerisierbaren Schicht und den gewünschten Eigenschaften. Das Schmelzen ist aber unbedingt zu vermeiden. Die Temperatur an der Oberfläche wird erfindungsgemäß daher so eingestellt, dass die Temperatur der fotopolymerisierbaren Schicht in jedem Falle unterhalb deren Schmelztemperatur liegt. Die Temperatur an der Oberfläche liegt im Regelfalle bei 70 bis 120°C, bevorzugt 80 bis 110°C und besonders bevorzugt bei 90 bis 100°C. Die Oberflächentemperatur kann beispielsweise mit einem handelsüblichen kontaktlosen Thermometer gemessen werden.

Die Kalanderwalze kann unbeheizt sein. Es kann aber auch vorteilhaft sein, die Kalanderwalze -beispielsweise mittels einer Innenheizung- auf eine Temperatur größer als Raumtemperatur aber kleiner als die zum Verbinden gewählte Oberflächentemperatur der fotopolymerisierbaren Schicht aufzuheizen. Hierdurch werden unnötige Wärmeverluste vermieden, beispielsweise bei besonders großen Hülsen. Im Regelfalle ist die Temperatur der Kalanderwalze zumindest 10°C geringer als die Temperatur der Oberfläche. Bewährt haben sich Temperaturen von 25 bis 85°C, bevorzugt 30 bis 75°C und besonders bevorzugt 35 bis 65°C.

Hinsichtlich der Geschwindigkeit, mit der die Wärmequelle axial bewegt wird, haben sich 0,5 bis 10 cm/min, bevorzugt 1 bis 6 cm/min und besonders bevorzugt 2 bis 4 cm/min bewährt, ohne dass die Erfindung darauf beschränkt sein soll.

Besonders bevorzugt erfolgt das Kalandrieren so, dass sich die beschichtete Hülse beim Kalandrieren in der Richtung (7) dreht. Die bevorzugte Drehrichtung ist in Fig.1 mit dem Pfeil (7) bezeichnet und lässt sich durch entsprechende Einstellung der Drehrichtung der Walzen erreichen. Da sich die Kalanderwalze und die beschichtete Hülse beim Kalandrieren gegeneinander drehen, wird bei dieser Drehrichtung die obere Schnittkante (6) in Richtung abnehmender Schichtdicke kalandriert. Hierdurch wird vorteilhaft ein Aufstellen des Spaltes vermieden, wenngleich es in Spezialfällen auch möglich ist, in umgekehrter Richtung zu kalandrieren.

Mittels des erfindungsgemäßen Verfahrens wird die Schicht in ausreichendem Maße erhitzt, um eine sehr feste Verbindung der Schnittkanten zu erreichen. Die Verbindung erfolgt hauptsächlich im oberen Bereich der fotopolymeren Schicht. Es lässt sich durch Zugdehnungsmessungen zeigen, dass die Festigkeit der Schicht im Bereich der Naht genauso gut ist, wie in Bereichen außerhalb der Naht.

Gleichzeitig wird die Wärmebelastung des gesamten Sleeves gering gehalten. Insbesondere wird das Klebeband thermisch viel weniger belastet, als beim Erhitzen der gesamten Schicht. Die Schicht wird immer nur an einer Stelle, aber nicht über die gesamte Länge thermisch belastet und behält dadurch weitgehend ihre Elastizität. Plastisches Deformieren der Schicht wird weitgehend vermieden. Vorteilhaft führt das Verfahren daher zu Sleeves mit einer besonders hohen Maßhaltigkeit.

Beim erfindungsgemäßen Verfahren verdampfen aufgrund der vergleichsweise niedrigen Temperaturbelastung beim Kalandrieren Monomere nicht oder nur in unwesentlichem Maße. Auch bleibt der Effekt der Rückseitenvorbelichtung erhalten. Beides trägt zu einer gleichbleibend hohen Schichtqualität bei, einer Voraussetzung für qualitativ hochwertige Druckformen.

Nach dem Verschließen der Naht wird der bearbeitete Hohlzylinder / fertige Sleeve wieder vom Trägerzylinder abgenommen (Verfahrensschritt (g)).

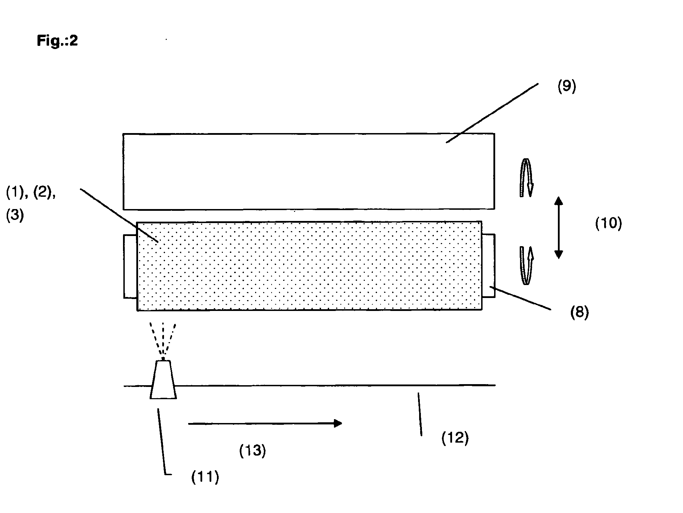

Die erfindungsgemäße Apparatur zur Ausführung des Verfahrens ist in Figur 2 dargestellt.

Die Apparatur weist einen Trägerzylinder (8) sowie eine Kalanderwalze (9) auf. Beide Zylinder sind drehbar gelagert. Die Aufhängungen der Zylinder sind der Übersichtlichkeit halber nicht dargestellt. Mindestens eine der beiden Walzen ist darüber hinaus beweglich gelagert, so dass die Walzen zusammen und auseinander gefahren werden können. Dies ist durch den Doppelpfeil (10) schematisch dargestellt. Die Kalanderwalze kann beheizbar sein. Sie sollte möglichst wenig Haftung zur fotopolymerisierbaren Schicht aufweisen. Sie kann beispielsweise poliert sein oder eine Beschichtung zur Entklebung, beispielsweise eine Teflon-Beschichtung aufweisen. Bei dem Trägerzylinder (8) handelt es sich bevorzugt um einen Luftzylinder.

Erfindungsgemäß umfasst die Apparatur weiterhin eine auf die Oberfläche der Apparatur gerichtete Wärmequelle (11). Hierbei kann es sich beispielsweise um einen Heißluftfön handeln. Die Wärmequelle ist axial zum Trägerzylinder (8) verschiebbar auf einer geeigneten Vorrichtung (12) gelagert. Die axiale Bewegung wird durch eine geeignete Antriebseinheit hervorgerufen (nicht dargestellt).

Die Apparatur kann selbstverständlich noch weitere Baugruppen umfassen. Als Hilfsmittel zum Montieren kann beispielsweise eine Hilfswalze vorgesehen sein, deren Abstand zum Luftzylinder eingestellt werden kann. Eine Hilfswalze wird bevorzugt unterhalb des Luftzylinders angeordnet. Bevorzugt handelt es sich bei der Hilfswalze um eine Gummiwalze. Die Apparatur kann weiterhin eine Aufgabevorrichtung für die fotopolymerisierbare Schicht und/oder die Klebefolie aufweisen. Bei der Aufgabevorrichtung kann es sich beispielsweise einfach um einen Montagetisch handeln, auf den die fotopolymerisierbare Schicht und/oder die Klebefolie gelegt werden und von dort aus gleichmäßig in den Spalt zwischen Hülse und Hilfswalze eingeschoben werden können. Dies kann von Hand bevorzugt mittels einer geeigneten Schiebevorrichtung geschehen. Weitere Einzelheiten zu derartigen Zusatzvorrichtungen sind beispielsweise in DE 103 18 042.7 offenbart.

Im Folgenden sei beispielhaft der Betrieb der Apparatur erläutert, ohne dass die Erfindung damit auf diese Betriebsweise beschränkt sein soll.

Zum Ausführen des Verfahrens wird zunächst eine Hülse (1) auf den Trägerzylinder (8) aufgeschoben. Die Hülse kann bereits vor dem Aufbringen mit einer Klebeschicht (2) und der fotopolymerisierbaren Schicht (3) versehen worden sein. Sie kann aber auch erst nach dem Aufbringen auf den Trägerzylinder mit der Klebeschicht und der fotopolymerisierbaren Schicht versehen werden. Dies kann beispielsweise erfolgen, indem man Klebefolie auf einem Montagetisch zurechtschneidet, den Trägerzylinder in Drehung versetzt und die Folie langsam bis in den Spalt zwischen einer Hilfswalze und dem mit der Hülse versehenen Trägerzylinder (8) einschiebt. Durch die Drehung wird die Klebefolie mitgenommen, wobei die Hilfswalze die Folie auf die Hülse drückt, so dass die Klebefolie blasenfrei an der Hülse festklebt. Danach wird die Schutzfolie von der Klebfolie abgezogen. Die Hülse ist nun mit einer Haftschicht versehen. Im nächsten Schritt wird der zurechtgeschnittene fotopolymerisierbare Schichtenverbund in den Spalt eingeschoben, mitgenommen und von der Hilfswalze festgedrückt. Die gegebenenfalls vorbelichtete Unterseite der Schicht ist dabei zur Hülse hin gerichtet. Falls die fotopolymerisierbare Schicht eine zweite, abziehbare Folie aufweist, wird diese vorher abgezogen.

Nach dem Abziehen der Trägerfolie des Schichtenverbundes werden die Kalanderwalze und der mit Hülse, Haftschicht und fotopolymerisierbarer Schicht versehene Luftzylinder in Kontakt miteinander gebracht und in Drehung versetzt. Die bevorzugte Drehrichtung beim Kalandrieren ist (7). Danach beginnt man mittels der Wärmequelle (11) die fotopolymerisierbare Schicht oberflächlich, beispielsweise mittels eines heißen Gasstromes (14) zu erwärmen. Die Wärmequelle (11) bewegt sich dabei axial zum Trägerzylinder. Dies ist in Fig. 2 mittels des Pfeiles (13) angedeutet. Die Kombination der axialen Bewegung der Wärmequelle (11) mit der Drehbewegung der Hülse führt dazu, dass sich der Fokus der Wärmequelle in Form einer Schraubenbewegung über die Oberfläche der Hülse fortbewegt.

Die Verfahrensschritte (a) bis (g) können in dieser Reihenfolge durchgeführt werden. Es sind aber auch Variationen möglich. So ist es durchaus möglich, die Haftschicht (Schritt (b)) und die fotopolymerisierbare Schicht (Schritt (d)) zunächst auf die Hülse aufzubringen, und erst danach die beschichtete Hülse auf den Trägerzylinder aufzuschieben (b).

Die durch das erfindungsgemäße Verfahren erhältlichen zylindrischen, endlos-nahtlosen Flexodruckelemente sind von anderen Sleeves leicht unterscheidbar. Spuren des Gehrungsschnittes sind im Bereich der verschlossenen Naht mittels geeigneter Analysenmethoden (z.B. der mikroskopischen Betrachtung, ggf. mittels polarisiertem Licht) als Unstetigkeitsstelle noch zu erkennen. Sofern vorbelichtet wurde, ist die Naht im unteren Schichtbereich deutlich zu erkennen. Dennoch wird eine im Hinblick die Druckeigenschaften völlig einheitliche Druckschicht erhalten, so dass keine sichtbare Naht im Druckbild mehr vorhanden ist. Zugdehnungsmessungen mit Schichtproben aus dem Bereich der verschlossenen Naht sowie solchen ohne Naht weisen vergleichbare Werte auf.

Die erfindungsgemäßen Flexodruckelemente eignen sich hervorragend als Ausgangsmaterial zur Herstellung von zylindrischen, endlos-nahtlosen Flexodruckformen.

Die Weiterverarbeitung zu Flexodruckformen kann nach verschiedenen Techniken erfolgen. Die Flexodruckelemente können beispielsweise auf bekannte Art und Weise bildmäßig belichtet, und die unbelichteten Bereiche der reliefbildenden Schicht anschließend mittels eines geeigneten Entwicklungsprozesses entfernt werden. Die bildmäßige Belichtung kann grundsätzlich durch Umhüllen des Sleeves mit einer fotografischen Maske und Belichten durch die Maske hindurch erfolgen.

Bevorzugt wird die Bebilderung aber mittels digitaler Masken vorgenommen. Derartige Masken sind auch als In-situ-Masken bekannt. Hierzu wird zunächst eine digital bebilderbare Schicht auf die fotopolymerisierbare Schicht des Sleeves aufgebracht.

Bevorzugt handelt es sich bei der digital bebilderbaren Schicht um eine Schicht, ausgewählt aus der Gruppe von IR-ablativen Schichten, Ink-Jet-Schichten oder thermografisch beschreibbaren Schichten.

IR-ablative Schichten bzw. Masken sind für die Wellenlänge des aktinischen Lichtes opak und umfassen üblicherweise ein Bindemittel sowie mindestens einen IR-Absorber wie beispielsweise Ruß. Ruß sorgt auch dafür, dass die Schicht opak ist. In die IR-ablative Schicht kann mittels eines IR-Lasers eine Maske eingeschrieben werden, d.h. die Schicht wird an den Stellen, an denen sie vom Laserstrahl getroffen wird, zersetzt und abgetragen. Beispiele für die Bebilderung von Flexodruckelementen mit IR-abla-tiven Masken sind beispielweise in EP-A 654 150 oder EP-A 1 069 475 offenbart.

Bei Ink-Jet-Schichten wird eine mit Ink-Jet-Tinten beschreibbare, für aktinisches Licht durchlässige Schicht, beispielsweise eine Gelatine-Schicht aufgetragen. Auf diese wird mittels Ink-Jet-Druckern eine Maske mit opaker Tinte aufgetragen. Beispiele sind in EP-A 1 072 953 offenbart.

Bei thermografischen Schichten handelt es sich um Schichten, die Substanzen enthalten, die sich unter dem Einfluss von Hitze schwarz färben. Derartige Schichten umfassen beispielsweise ein Bindemittel und ein organisches Silbersalz und können mittels eines Druckers mit Thermokopf bebildert werden. Beispiele sind in EP-A 1 070 989 offenbart.

Die digital bebilderbaren Schichten können durch Lösen bzw. Dispergieren aller Bestandteile der jeweiligen Schicht in einem geeigneten Lösemittel und Aufbringen der Lösung auf die fotopolymerisierbare Schicht des zylindrischen Flexodruckelementes, gefolgt vom Verdampfen des Lösemittels, hergestellt werden. Das Aufbringen der digital bebilderbaren Schicht kann beispielsweise durch Aufsprühen oder mittels der von EP-A 1 158 365 beschriebenen Technik erfolgen. Bevorzugt werden zur Herstellung der digital bebilderbaren Schicht in Wasser oder überwiegend wässrigen Lösemittelmischungen lösliche Bestandteile verwendet.

Nach dem Aufbringen der digital bebilderbaren Schicht wird diese mittels der jeweils geeigneten Technik bebildert und anschließend der Sleeve durch die gebildete Maske hindurch in prinzipiell bekannter Art und Weise mittels aktinischem Licht bestrahlt. Als aktinisches, also chemisch "wirksames" Licht eignet sich in bekannter Art und Weise insbesondere UVA- bzw. UV/VIS-Strahlung. Rundbelichter zur gleichmäßigen Belichtung von Sleeves sind kommerziell erhältlich.

Das Entwickeln der bildmäßig belichteten Schicht kann auf konventionelle Art und Weise mittels eines Lösemittels oder eines Lösemittelgemisches erfolgen. Dabei werden die nicht belichteten, d.h. die von der Maske abgedeckten Bereiche der Reliefschicht durch Auflösen im Entwickler entfernt, während die belichteten, d.h. die vernetzten Bereiche erhalten bleiben. Die Maske oder die Reste der Maske werden ebenfalls vom Entwickler entfernt, falls die Komponenten darin löslich sind. Falls die Maske nicht im Entwickler löslich ist, wird sie gegebenenfalls vor dem Entwickeln mit Hilfe eines zweiten Lösemittels entfernt.

Die Entwicklung kann auch thermisch erfolgen. Bei der thermischen Entwicklung wird kein Lösemittel eingesetzt. Statt dessen wird die reliefbildende Schicht nach der bildmäßigen Belichtung mit einem absorbierenden Material in Kontakt gebracht und erwärmt. Bei dem absorbierenden Material handelt es sich beispielsweise um ein poröses Vlies, beispielsweise aus Nylon, Polyester, Cellulose oder anorganischen Materialien. Es wird auf eine solche Temperatur erwärmt, dass sich die nicht polymerisierten Anteile der reliefbildenden Schicht verflüssigen und vom Vlies aufgesogen werden können. Das vollgesogene Vlies wird anschließend entfernt. Einzelheiten zur thermischen Entwicklung sind beispielsweise von US 3,264,103, US 5,175,072, WO 96/14603 oder WO 01/88615 offenbart. Die Maske kann gegebenenfalls vorher mittels eines geeigneten Lösemittels oder ebenfalls thermisch entfernt werden.

Die Herstellung von zylindrischen Flexodruckformen aus den fotopolymerisierbaren, endlos-nahtlosen Flexodruckelementen kann auch mittels Laser-Direktgravur vorgenommen werden.

Bei diesem Verfahren wird die fotopolymerisierbare Schicht zunächst ohne Auflegen einer Maske vollständig im gesamten Volumen mittels aktinischem Licht vernetzt. Anschließend wird in die vernetzte Schicht mittels eines oder mehrerer Laser ein Druckrelief eingraviert.

Die vollflächige Vernetzung kann mit üblichen Rundbelichtern für Sleeves wie oben beschrieben erfolgen. Besonders vorteilhaft kann sie aber auch in Anlehnung an das in WO 01/39897 beschriebene Verfahren erfolgen. Hierbei wird in Anwesenheit eines Schutzgases, welches schwerer ist als Luft, beispielsweise CO₂ oder Ar belichtet. Das fotopolymerisierbare, zylindrische Flexodruckelement wird hierzu in ein mit Schutzgas gefülltes Tauchbecken abgesenkt, dessen Wände bevorzugt mit einem reflektierenden Material, beispielsweise Aluminium-Folie ausgekleidet sind. Das Absenken erfolgt bevorzugt so, dass die Rotationsachse des zylindrischen Flexodruckelementes vertikal steht. Die Füllung des Tauchbeckens mit Schutzgas kann beispielsweise so erfolgen, indem man Trockeneis in das Tauchbecken einbringt, welches beim Verdampfen den Luftsauerstoff verdrängt. Die Füllung kann aber auch so erfolgen, indem man das Becken durch am oder in der Nähe des Beckenbodens eingebaute Düsen langsam mit dem Schutzgas füllt. Es ist hierbei nicht erforderlich, den Sauerstoff vollständig zu verdrängen. Im Regelfalle ist die Reduktion der Sauerstoffkonzentration auf weniger als 5 Vol. % O₂, bevorzugt weniger als 3 Vol. % und besonders bevorzugt weniger als 1 Vol. % ausreichend.

Anschließend wird von oben her mittels aktinischem Licht belichtet. Es können hierzu im Prinzip die üblichen UV- bzw. UVNIS-Quellen für aktinisches Licht verwendet werden. Bevorzugt werden Strahlungsquellen eingesetzt, welche im wesentlichen sichtbares Licht und keine oder nur geringe Anteile von UV-Licht emittieren. Bevorzugt sind Lichtquellen, die Licht mit einer Wellenlänge von mehr als 300 nm emittieren. Beispielsweise können übliche Halogenlampen verwendet werden. Das Verfahren hat den Vorteil, dass die bei kurzwelligen UV-Lampen übliche Ozon-Belastung nahezu vollständig unterbleibt, Schutzmaßnahmen gegen starke UV-Strahlung im Regelfalle unnötig sind und keine aufwendigen Apparaturen nötig sind. Somit kann dieser Verfahrensschritt besonders wirtschaftlich durchgeführt werden.

Bei der Laser-Direktgravur absorbiert die Reliefschicht Laserstrahlung in einem solchen Ausmaße, so dass sie an solchen Stellen, an denen sie einem Laserstrahl ausreichender Intensität ausgesetzt ist, entfernt oder zumindest abgelöst wird. Vorzugsweise wird die Schicht dabei ohne vorher zu schmelzen verdampft oder thermisch oder oxidativ zersetzt, so dass ihre Zersetzungsprodukte in Form von heißen Gasen, Dämpfen, Rauch oder kleinen Partikeln von der Schicht entfernt werden.

Zur Gravur der erfindungsgemäß eingesetzten reliefbildenden Schichten eignen sich insbesondere Laser, die eine Wellenlänge von 9000 nm bis 12 000 nm aufweisen. Zu nennen sind hier insbesondere CO₂-Laser. Die in der reliefbildenden Schicht verwendeten Bindemittel absorbieren die Strahlung derartiger Laser in ausreichendem Maße, um graviert werden zu können.

Zur Gravur kann ein Lasersystem eingesetzt werden, welches nur über einen einzigen Laserstrahl verfügt. Bevorzugt werden aber Lasersysteme eingesetzt, die zwei oder mehrere Laserstrahlen aufweisen. Bevorzugt ist mindestens einer der Strahlen speziell zum Erzeugen von Grobstrukturen und mindestens einer der Strahlen speziell zum Schreiben von Feinstrukturen angepasst. Mit derartigen Systemen lassen sich besonders elegant qualitativ hochwertige Druckformen erzeugen. Beispielsweise kann der Strahl zur Erzeugung der Feinstrukturen eine geringere Leistung aufweisen als die Strahlen zur Erzeugung von Grobstrukturen. Zur Lasergravur besonders geeignete Mehrstrahl-Lasersysteme sowie geeignete Gravurverfahren sind prinzipiell bekannt und beispielsweise in EP-A 1 262 315 und EP-A 1 262 316 offenbart.

Die Tiefe der einzugravierenden Elemente richtet sich nach der Gesamtdicke des Reliefs und der Art der einzugravierenden Elemente und wird vom Fachmann je nach den gewünschten Eigenschaften der Druckform bestimmt. Die Tiefe der einzugravierenden Reliefelemente beträgt zumindest 0,03 mm, bevorzugt 0,05 mm - genannt ist hier die Mindesttiefe zwischen einzelnen Rasterpunkten. Druckformen mit zu geringen Relieftiefen sind für das Drucken mittels Flexodrucktechnik im Regelfalle ungeeignet, weil die Negativelemente mit Druckfarbe vollaufen. Einzelne Negativpunkte sollten üblicherweise größere Tiefen aufweisen; für solche von 0,2 mm Durchmesser ist üblicherweise eine Tiefe von mindestens 0,07 bis 0,08 mm empfehlenswert. Bei weggravierten Flächen empfiehlt sich eine Tiefe von mehr als 0,15 mm, bevorzugt mehr als 0,4 mm. Letzteres ist natürlich nur bei einem entsprechend dicken Relief möglich.

Vorteilhaft kann die erhaltene zylindrische Flexodruckform im Anschluss an die Lasergravur in einem weiteren Verfahrensschritt nachgereinigt werden. In manchen Fällen kann dies durch einfaches Abblasen mit Druckluft oder Abbürsten geschehen. Es ist aber bevorzugt, zum Nachreinigen ein flüssiges Reinigungsmittel einzusetzen, um auch Polymerbruchstücke vollständig entfernen zu können.

Geeignet sind beispielsweise wässrige Reinigungsmittel, welche im Wesentlichen aus Wasser sowie optional geringen Mengen von Alkoholen bestehen, und die zur Unterstützung des Reinigungsvorganges Hilfsmittel, wie beispielsweise Tenside, Emulgatoren, Dispergierhilfsmittel oder Basen enthalten können. Geeignet sind auch "Wasser-in-Öl"-Emulsionen, wie von EP-A 463 016 offenbart.

Die mittels digitaler Bebilderung oder mittels Laser-Direktgravur erhaltenen zylindrischen Druckformen eignen sich hervorragend zum Drucken von Endlos-Mustern. Sie können auch im Bereich der Naht beliebige druckende Bereiche aufweisen, ohne dass die Naht noch im Druckbild zu sehen ist. Falls Klebeband als Haftschicht verwendet wurde, kann die Druckschicht sehr einfach wieder von der Hülse abgezogen und diese wieder verwendet werden. Es können hierbei Hülsen verschiedenen Typs verwendet werden, beispielsweise kompressible Hülsen oder hard-coated Hülsen.

Die folgenden Beispiele sollen die Erfindung näher erläutern:

### Messmethoden:

Bestimmung der statischen Scherfestigkeit der Klebefolie in Anlehnung an DIN EN *1943 "Klebebänder - Messung des Scherwiderstandes unter statischer Belastung"* (Ausgabe Januar 2003).

Es wurde gemäß dem beschriebenen Verfahren A getestet. Für den Test wurde eine in der DIN EN1943 spezifizierte Stahlplatte eingesetzt. Die Stahlplatte wurde senkrecht in einer Haltevorrichtung eingespannt. Hierauf wurde ein Probestreifen der Klebefolie von 25 mm Breite geklebt, so dass die Kontaktfläche zur Stahlplatte genau 25 mm x 25 mm betrug und ein Teil des Klebebandes senkrecht unter der Stahlplatte hing. An das frei hängende Ende des Klebebandes wurde die Prüfmasse von 1 kg gehängt. Der Test wurde bei 70°C durchgeführt. Es wurde die Zeit bestimmt, bis das Klebeband 2,5 mm auf der Stahlplatte nach unten gerutscht war.

### Bereitstellung des Schichtenverbundes:

### Schichtelement 1:

Für die fotopolymerisierbare, elastomere Schicht wurden die folgenden Ausgangsmaterialien eingesetzt:

| Komponente | Menge |
|---|---|
| SBS-Blockcopolymeres (M_{w} 125000 g/mol, Styrolanteil 30 Gew. % (Kraton D 1102) | 55 % |
| Weichmacher Polybutadienöl | 32 % |
| Monomer Hexandioldiacrylat | 10 % |
| Fotoinitiator | 2 % |
| Additive (thermischer Stabilisator, Farbstoff) | 1 % |
| Summe | 100 % |

Das als Ausgangsmaterial für das erfindungsgemäße Verfahren eingesetzte Schichtelement wurde in prinzipiell bekannter Art und Weise Aus den Komponenten durch Schmelzextrusion und Kalandrieren zwischen zwei entklebend beschichtete abziehbare PET-Folien hergestellt (Trägerfolie und so genannte zweite Folie). Die fotopolymerisierbare Schicht wies eine Dicke von 1,14 mm auf.

### Schichtelement 2:

Es wurde ein Schichtelement auf gleiche Art und Weise wie bei Schichtelement 1 beschrieben hergestellt, nur wurden die folgenden Ausgangsmaterialien für die fotopolymerisierbare Schicht verwendet.

| Komponente | Menge |
|---|---|
| SBS-Blockcopolymeres (M_{w} 125000 g/mol, Styrolanteil 30 Gew. % , verstreckt mit ca. 33 % Öl (Kraton D 4150) | 58 % |
| Sekundäres Bindemittel SB-Zweiblockcopolymer, M_{w} 230 000 g/mol (Kraton DX 1000) | 10 % |
| Weichmacher Polybutadienöl | 23 % |
| Monomer Hexandioldiacrylat | 7 % |
| Fotoinitiator | 1 % |
| Additive (thermischer Stabilisator, Farbstoffe) | 1 % |
| Summe | 100 % |

### Herstellung der zylindrischen, endlos-nahtlosen Flexodruckelemente:

### Beispiel 1:

Zur Durchführung des Verfahrens wurde eine Apparatur des oben beschriebenen Typs eingesetzt (Fig. 2). Die Kalanderwalze war teflonisiert. Die Apparatur wies zusätzlich eine unterhalb des Luftzylinders angebrachte gummierte Hilfswalze sowie einen einfachen Montagetisch auf. Als verschiebbare Wärmequelle wies die Apparatur ein Heißluftgebläse auf.

Eine Hülse (Blue Light, Fa. Rotec, Innendurchmesser 136,989 mm, Außendurchmesser 143,223 mm, Länge 65 cm) wurde auf den Luftzylinder der oben beschriebenen Apparatur aufgeschoben und fixiert. Die Hülse wurde anschließend mit einem 500 µm dicken kompressiblen Klebeband mit hoher Scherfestigkeit (Rogers SA 2120, Scherfestigkeit bei 70°C > 100 h) spaltfrei belegt. Die kompressible Schicht des Klebebandes bestand aus einem offenzelligen PU-Schaum. Das Klebeband wurde mittels eines Gehrungsschnittes (Winkel etwa 7°) zurechtgeschnitten.

Schichtelement 1 wurde für 12 s mit aktinischem Licht von der Rückseite her durch die eine der beiden PET-Folie hindurch belichtet. Anschließend wurde Schichtelement 1 zurechtgeschnitten. Die beiden Stoßkanten wurden mit einer Winkelung von 50° und 55°, jeweils bezogen auf die Senkrechte, zugeschnitten, und zwar so, dass die vorbelichtete Seite der Schicht kürzer war als die nicht vorbelichtete Seite. Das Schichtelement wurde auf den Montagetisch gelegt, so dass die vorbelichtete Seite nach oben wies, und auf der vorbelichteten Seite wurde die Folie inklusive der Entklebeschicht abgezogen.

Der Trägerzylinder mit der Hülse wurde in Drehung versetzt und das Schichtelement wurde mit der vorbelichteten Seite nach oben zeigend in den Spalt zwischen Hilfswalze und Hülse langsam vollständig eingeschoben und somit auf die mit der Klebefolie versehene Hülse aufgebracht. Nach dem Aufbringen der Schicht wurde die zweite PET-Folie inklusive der Entklebeschicht abgezogen.

Die Kalanderwalze wurde in Drehung (50 Upm) versetzt und mit der fotopolymerisierbaren Schicht in Kontakt gebracht. Der Abstand zwischen der Kalanderwalze und dem Luftzylinder wurde so eingestellt, dass ein "negativer Spalt" von 50 bis 80 µm resultierte (d.h. die Kalanderwalze wurde 50 bis 80 µm in die elastomere, fotopolymerisierbare Schicht eingedrückt). Die Drehung erfolgte in Richtung (7). Die Temperatur der Kalanderwalze betrug 50°C.

Danach wurde das Heißluftgebläse eingeschaltet und das Gebläse mit einer Geschwindigkeit von ca. 3 cm/min vom einen Ende der mit der fotopolymerisierbaren Schicht versehenen Hülse zum anderen Ende bewegt (Dauer ca. 20 min). Die Leistung des Heißluftgebläses wurde so bemessen, dass die Oberflächentemperatur der fotopolymerisierbaren Schicht, gemessen mittels eines kontaktlosen Thermometers an der gerade vom Gasstrom erwärmten Stelle, ca. 90 bis 100°C betrug. Danach wurden die Walzen wieder auseinander gefahren, und die beschichtete Hülse wieder vom Luftzylinder abgenommen.

Es wurde ein zylindrisches, fotopolymerisierbares endlos-nahtloses Flexodruckelement erhalten. Die Oberfläche des Druckelementes war im Bereich der Naht vollkommen eben und es waren keinerlei Spuren der Naht zu entdecken. Ein Schnitt im Bereich der Naht zeigte, dass die Naht im vorbelichteten Schichtbereich nicht vollständig verschlossen war, der Verschluss im oberen Schichtbereich war jedoch so gut, dass insgesamt eine äußerst haltbare Verbindung erhalten wurde.

### Beispiel 2:

Es wurde wie in Beispiel 1 vorgegangen, nur wurde Schichtelement 2 als Ausgangsmaterial eingesetzt. Die Oberflächentemperatur des Flexdruckelementes beim Kalandrieren betrug 100°C.

Es wurde ein zylindrisches, fotopolymerisierbares endlos-nahtloses Flexodruckelement erhalten.

### Beispiel 3:

Es wurde wie in Beispiel 1 vorgegangen, nur wurden 5 Hülsen unmittelbar nacheinander zu einem endlos-nahtlosen Flexodruckelement verarbeitet. Die Temperatur der Trägerwalze blieb unverändert.

### Vergleichsbeispiel 1:

Es wurde wie in Beispiel 1 vorgegangen, nur wurde das Heißluftgebläse nicht verwendet. Statt dessen wurde die Kalandrierwalze auf ca. 130°C beheizt und die elastomere Schicht ca. 15 min lang kalandriert. Die Oberflächentemperatur der fotopolymerisierbaren Schicht betrug auf der gesamten Länge ca. 90 bis 100°C.

### Vergleichsbeispiel 2:

Es wurde wie in Vergleichsbeispiel 1 vorgegangen, nur wurden 5 Hülsen unmittelbar nacheinander zu einem endlos-nahtlosen Flexodruckelement verarbeitet. Die Temperatur der (an sich nicht beheizten) Trägerwalze stieg von Versuch zu Versuch an. Das letzte Flexodruckelement der Versuchsreihe wies Wellen in der Oberfläche auf. Es wurde wie unten beschrieben weiter verarbeitet und getestet.

### Weiterverarbeitung zu Flexodruckformen

### Beispiel 3

Auf das zylindrische, fotopolymerisierbaren Flexodruckelemente gemäß Versuch 1 wurde in prinzipiell bekannter Art und Weise mittels eines Ringcoaters wie von DE 299 02 160 beschrieben eine IR-ablative digital bebilderbare Schicht aus Ruß und einem Bindemittel aufgebracht.

Anschließend wurde das erhaltene fotoempfindliche Flexodruckelement mit IR-ablativer Schicht mittels eines Nd/YAG-Lasers bildmäßig mit einem Endlos-Muster beschrieben. Das Muster wurde so gewählt, dass auch druckende Bereiche im Bereich der Nahtverbindung vorgesehen wurden.

Der bebilderte Sleeve wurde in einem Rundbelichter 20 min. mit aktinischem Licht belichtet, danach mit Hilfe eines Flexoauswaschmittels (nylosolv II^{®}) entwickelt, 2h bei 40°C getrocknet und 15 min.UV/A und UV/C nachbelichtet.

Es wurden Zugdehnungsmessungen mit verschiednen Stücken der Schicht vorgenommen (jeweils Dreifachbestimmung):

| | Zugdehnung[%] |
|---|---|
| | (Mittelwert aus drei Messungen) |
| Vollfläche ohne Spalt | 260 % |
| Vollfläche mit Spalt (rechts) | 280 % |
| Vollfläche mit Spalt (Mitte) | 279 % |
| Vollfläche mit Spalt (links) | 281% |

### Beispiel 4

Es wurde wie unter Beispiel 3 beschrieben vorgegangen, nur wurde das Flexodruckelement aus Beispiel 2 eingesetzt.

### Vergleichsbeispiele 3 und 4

Es wurde wie in Beispiel 3 vorgegangen, nur wurden die Flexodruckelemente aus den Vergleichsbeispielen 1 und 2 eingesetzt.

### Druckversuche

Mit den aus den Versuchen und Vergleichsversuchen erhaltenen zylindrischen Flexodruckformen wurden Druckversuche unternommen.

Druckmaschine: W&H (Windmöller und Hölscher), Druckgeschwindigkeit: 150 m/min, Bedruckstoff: PE Folie

Ein Vierfarbandruck zeigte bei den erfindungsgemäßen Beispielen weder in den Einzelfarbauszügen noch im Überdruck aller Farben einen Spalt, während bei den Vergleichsversuchen der Spalt noch zu sehen war.

Die Ergebnisse sind in Tabelle 1 zusammengefasst.

**Tabelle 1: Ergebnisse der Versuche und Vergleichsversuche**

| Flexodruckform Nr. | Hergestellt aus Flexodruckelement Nr. | Kommentar |
|---|---|---|
| Beispiel 3 | Beispiel 1 | Einheitliches Endlos-Motiv, kein Spalt im Druckbild sichtbar |
| Beispiel 4 | Beispiel 2 | Einheitliches Endlos-Motiv, kein Spalt im Druckbild sichtbar |
| Vergleichsbeispiel 3 | Vergleichsbeispiel 1 | Leichte Störungen im Druckbild |
| Vergleichsbeispiel 4 | Vergleichsbeispiel 2 | Deutliche Störungen im Druckbild |

Die Beispiele und Vergleichsbeispiele zeigen, dass mittels des erfindungsgemäßen Verfahrens Sleeves hervorragender Qualität erhalten werden.

Es wird nicht mehr der gesamte Sleeve einer Temperaturbelastung ausgesetzt, sondern immer nur kleine Bereiche, während die anderen Bereiche schon wieder abkühlen können oder noch gar nicht aufgeheizt sind.

Die Zugdehnungsmessung von Proben der vernetzten Schicht im Bereich des Spaltverschlusses und ohne Spalt zeigen, dass die Zugdehnung im Bereich des Spaltes sogar besser ist, als in Bereichen ohne Spalt.

Der Spalt ist im Druckbild nicht mehr zu sehen. Störungen im Druckbild aufgrund von Unebenheiten der Druckform werden nicht mehr beobachtet.

## Patentansprüche

1. Verfahren zur Herstellung von fotopolymerisierbaren zylindrischen, endlos-nahtlosen Flexodruckelementen, bei dem man als Ausgangsmaterial einen Schichtenverbund umfassend mindestens
• eine Schicht aus einem fotopolymerisierbaren Material, mindestens umfassend ein elastomeres Bindemittel, ethylenisch ungesättigte Monomere und einen Fotoinitiator, sowie
• eine von der Schicht abziehbare Trägerfolie,
einsetzt, und wobei das Verfahren die folgenden Schritte umfasst:
(a) Zurechtschneiden der zu verbindenden Kanten des Schichtenverbundes mittels Gehrungsschnitten,
(b) Aufschieben und Arretieren eines Hohlzylinders auf einen drehbar gelagerten Trägerzylinder,
(c) Aufbringen einer Haftschicht auf die äußere Fläche des Hohlzylinders,
(d) Aufbringen des zurechtgeschnittenen Schichtenverbundes mit der von der abziehbaren Trägerfolie abgewandten Seite auf den mit der Haftschicht versehenen Hohlzylinder, wobei die mit dem Gehrungsschnitt versehenen Enden im Wesentlichen aufeinander liegen, aber nicht überlappen,
(e) Abziehen der Trägerfolie von der Schicht aus fotopolymerisierbarem Material,
(f) Verbinden der Schnittkanten, indem man die Oberfläche der fotopolymerisierbaren Schicht auf dem Hohlzylinder unter Erwärmen mit einer sich drehenden Kalanderwalze in Kontakt bringt, bis die Schnittkanten miteinander verbunden sind,
(g) Abziehen des bearbeiteten Hohlzylinders vom Trägerzylinder,
**dadurch gekennzeichnet, dass** man zum Erwärmen in Schritt (f) eine punktuell wirkende Wärmequelle einsetzt, welche die fotopolymerisierbare Schicht von der Oberseite her erwärmt, und wobei man die Wärmequelle axial zum Hohlzylinder über die gesamte Breite der fotopolymerisierbaren Schicht verschiebt.

2. Verfahren gemäß Anspruch 1, **dadurch gekennzeichnet, dass** es sich bei der punktuell wirkenden Wärmequelle um eine Vorrichtung zum Erzeugen eines warmen Gasstroms handelt.

3. Verfahren gemäß Anspruch 1 oder 2, **dadurch gekennzeichnet, dass** es sich bei der Haftschicht um eine doppelseitige Klebefolie handelt.

4. Verfahren gemäß Anspruch 3, **dadurch gekennzeichnet, dass** die Klebefolie eine statische Scherfestigkeit gemessen nach DIN EN 1943 von mindestens 3 h bei 70°C aufweist.

5. Verfahren gemäß Anspruch 3 oder 4, **dadurch gekennzeichnet, dass** die Klebefolie mit Hilfe von Gehrungsschnitten zurechtgeschnitten wird.

6. Verfahren gemäß einem der Ansprüche 1 bis 5, **dadurch gekennzeichnet, dass** die Schicht aus fotopolymerisierbarem Material eine weitere abziehbare Folie auf der von der Trägerfolie abgewandten Seite der Schicht umfasst, welche vor Verfahrensschritt (c) abgezogen wird.

7. Verfahren gemäß einem der Ansprüche 1 bis 6, **dadurch gekennzeichnet, dass** man die Schicht aus fotopolymerisierbarem Material vor Verfahrensschritt (c) von der von der Trägerfolie abgewandten Seite her -direkt oder durch die zweite abziehbare Folie hindurch- mit aktinischem Licht vorbelichtet.

8. Verfahren gemäß Anspruch 7, **dadurch gekennzeichnet, dass** die Vorbelichtung vor Verfahrensschritt (a) erfolgt.

9. Verfahren gemäß einem der Ansprüche 1 bis 8, **dadurch gekennzeichnet, dass** sich der beschichtete Hohlzylinder beim Kalandrieren in der Richtung (7) dreht.

10. Verfahren gemäß einem der Ansprüche 1 bis 9, **dadurch gekennzeichnet, dass** die Temperatur der Oberfläche der fotopolymerisierbaren Schicht beim Kalandrieren 80 bis 100°C beträgt.

11. Verfahren gemäß einem der Ansprüche 1 bis 10, **dadurch gekennzeichnet, dass** es sich bei dem Trägerzylinder um einen Luftzylinder handelt.

12. Verfahren gemäß einem der Ansprüche 1 bis 11, **dadurch gekennzeichnet, dass** man in einem weiteren Verfahrensschritt (h) eine digital bebilderbare Schicht auf die fotopolymerisierbare Schicht aufbringt.

13. Verfahren gemäß Anspruch 12, **dadurch gekennzeichnet, dass** es sich bei der digital bebilderbaren Schicht um eine ausgewählt aus der Gruppe von IR-ablativen Schichten, Ink-Jet-Schichten oder thermografisch beschreibbaren Schichten handelt.

14. Apparatur zum Herstellen von zylindrischen fotopolymerisierbaren endlos-nahtlos Flexodruckelementen, mindestens umfassend einen drehbaren Trägerzylinder (8) zur Aufnahme von Hülsen, eine drehbare Kalanderwalze (9), wobei die Abstände zwischen dem Trägerzylinder und der Kalandrierwalze mittels geeigneter Mittel einstellbar sind, **dadurch gekennzeichnet, dass** die Vorrichtung weiterhin eine punktuell wirkende, auf die Oberfläche des Trägerzylinders gerichtete Wärmequelle (11) umfasst, welche axial zum Trägerzylinder (8) verschiebbar gelagert ist.

15. Apparatur gemäß Anspruch 14, **dadurch gekennzeichnet, dass** es sich bei der Wärmequelle (11) um eine Vorrichtung zum Erzeugen eines warmen Gasstromes handelt.

16. Apparatur gemäß Anspruch 14 oder 15, **dadurch gekennzeichnet, dass** die Kalanderwalze (9) beheizbar ist.

## Claims

1. A process for the production of photopolymerizable cylindrical, continuous seamless flexographic printing elements, in which a layer composite comprising at least
● a layer of photopolymerizable material at least comprising an elastomeric binder, ethylenically unsaturated monomers and a photoinitiator, and
● a substrate film which can be peeled off from the layer,
is used as starting material, the process comprising the following steps:
(a) cutting as required the edges of the layer composite to be joined, by means of miter cuts,
(b) pushing on and locking a hollow cylinder on a rotatably mounted support cylinder,
(c) applying an adhesion-promoting layer to the outer surface of the hollow cylinder,
(d) applying that side of the layer composite cut as required which faces away from the peelable substrate film to the hollow cylinder provided with the adhesion-promoting layer, the ends provided with the miter cut lying substantially one on top of the other but not overlapping,
(e) peeling off the substrate film from the layer of photopolymerizable material,
(f) joining the cut edges by bringing the surface of the photopolymerizable layer on the hollow cylinder into contact with a rotating calender roll while heating, until the cut edges have been joined to one another,
(g) peeling off the processed hollow cylinder from the support cylinder,
wherein a locally acting heat source which heats the photopolymerizable layer from the top being used for the heating in step (f), the heat source being displaced axially relative to the hollow cylinder over the entire width of the photopolymerizable layer.

2. The process according to claim 1, wherein the locally acting heat source is an apparatus for producing a warm gas stream.

3. The process according to claim 1 or 2, wherein the adhesion-promoting layer is a double-sided adhesive film.

4. The process according to claim 3, wherein the adhesive film has a static shear strength, measured according to DIN EN 1943, of at least 3 h at 70°C.

5. The process according to claim 3 or 4, wherein the adhesive film is cut to size with the aid of miter cuts.

6. The process according to any of claims 1 to 5, wherein the layer of photopolymerizable material comprises a further peelable film on that side of the layer which faces away from the substrate film, which peelable film is peeled off before process step (c).

7. The process according to any of claims 1 to 6, wherein the layer of photopolymerizable material is preexposed to actinic light from the side facing away from the substrate film, directly or through the second peelable film.

8. The process according to claim 7, wherein the preexposure is effected before process step (a).

9. The process according to any of claims 1 to 8, wherein the coated hollow cylinder rotates in the direction (7) during calendering.

10. The process according to any of claims 1 to 9, wherein the temperature of the surface of the photopolymerizable layer during calendering is from 80 to 100°C.

11. The process according to any of claims 1 to 10, wherein the support cylinder is an air cylinder.

12. The process according to any of claims 1 to 11, wherein a digitally imageable layer is applied to the photopolymerizable layer in a further process step (h).

13. The process according to claim 12, wherein the digitally imageable layer is one selected from the group consisting of IR-ablative layers, inkjet layers and thermographically inscribable layers.

14. An apparatus for the production of cylindrical photopolymerizable continuous seamless flexographic printing elements, at least comprising a rotatable support cylinder (8) for holding hollow cylinders, a rotatable calender roll (9), the distances between the support cylinder and the calender roll being adjustable by suitable means, wherein the apparatus furthermore comprises a locally acting heat source (11) which is directed toward the surface of the support cylinder and is mounted so as to be displaceable axially relative to the support cylinder (8).

15. The apparatus according to claim 14, wherein the heat source (11) is an apparatus for producing a warm gas stream.

16. The apparatus according to claim 14 or 15, wherein the calender roll (9) is heatable.

## Revendications

1. Procédé de fabrication d'éléments d'impression flexographique photopolymérisables, cylindriques, en continu et sans soudure, dans lequel on utilise comme matériau de départ un composite stratifié comprenant au moins :
● une couche formée d'un matériau photopolymérisable, comprenant au moins un liant élastomère, des monomères à insaturation éthylénique et un photoinitiateur, ainsi que
● une feuille de support détachable de la couche, et dans lequel le procédé comprend les étapes suivantes :
(a) on découpe à la bonne dimension les arêtes à relier du composite stratifié à l'aide de coupes en onglets,
(b) on déplace et on bloque un cylindre creux sur un cylindre de support monté à rotation,
(c) on applique une couche adhésive sur la surface externe du cylindre creux,
(d) on applique le composite stratifié découpé à la bonne dimension avec la face opposée à la feuille de support détachable sur le cylindre creux pourvu de la couche adhésive, les extrémités pourvues de la coupe en onglets s'appliquant sensiblement l'une sur l'autre, mais sans se chevaucher,
(e) on détache la feuille de support de la couche formée de matériau photopolymérisable,
(f) on relie les arêtes de coupe en amenant la surface de la couche photopolymérisable sur le cylindre creux, an appliquant de la chaleur, en contact avec un rouleau de calandre rotatif jusqu'à ce que les arêtes de coupe soient reliées l'une à l'autre, et
(g) on détache le cylindre creux traité du cylindre de support,
**caractérisé en ce que** l'on utilise, pour chauffer à l'étape (f), une source de chaleur agissant ponctuellement, qui chauffe la couche photopolymérisable par le dessus et dans lequel on déplace la source de chaleur axialement par rapport au cylindre creux sur toute la largeur de la couche photopolymérisable.

2. Procédé selon la revendication 1, **caractérisé en ce que** la source de chaleur agissant ponctuellement est un dispositif de production d'un flux gazeux chaud.

3. Procédé selon la revendication 1 ou 2, **caractérisé en ce que** la couche adhésive est une feuille adhésive double face.

4. Procédé selon la revendication 3, **caractérisé en ce que** la feuille adhésive présente une résistance au cisaillement statique, mesurée selon la norme DIN EN 1943, d'au moins 3 h à 70 °C.

5. Procédé selon la revendication 3 ou 4, **caractérisé en ce que** la feuille adhésive est découpée à la bonne dimension à l'aide de coupes en onglets.

6. Procédé selon l'une quelconque des revendications 1 à 5, **caractérisé en ce que** la couche de matériau photopolymérisable comprend une autre feuille détachable sur la face, opposée à la feuille de support, de la couche qui est détachée avant l'étape de procédé (c).

7. Procédé selon l'une quelconque des revendications 1 à 6, **caractérisé en ce que** l'on insole préalablement, à la lumière actinique, la couche de matériau photopolymérisable avant l'étape de procédé (c) par la face opposée à la feuille de support directement ou à travers la deuxième feuille détachable.

8. Procédé selon la revendication 7, **caractérisé en ce que** l'insolation préalable a lieu avant l'étape de procédé (a).

9. Procédé selon l'une quelconque des revendications 1 à 8, **caractérisé en ce que** le cylindre creux revêtu tourne, lors du calandrage, dans la direction (7).

10. Procédé selon l'une quelconque des revendications 1 à 9, **caractérisé en ce que** la température de la surface de la couche photopolymérisable lors du calandrage est de 80 à 100 °C.

11. Procédé selon l'une quelconque des revendications 1 à 10, **caractérisé en ce que** le cylindre de support est un cylindre à air.

12. Procédé selon l'une quelconque des revendications 1 à 11, **caractérisé en ce que** l'on applique, dans une autre étape de procédé (h), une couche imprimable numériquement sur la couche photopolymérisable.

13. Procédé selon la revendication 12, **caractérisé en ce que** la couche imprimable numériquement est une couche choisie dans le groupe des couches ablatives par IR, des couches à jet d'encre ou des couches imprimables par thermographie.

14. Appareil de fabrication d'éléments d'impression flexographiques cylindriques, photopolymérisables, en continu et sans soudure, comprenant au moins un cylindre de support rotatif (8) pour la réception de douilles, un rouleau de calandre rotatif (9), les distances entre le cylindre de support et le rouleau de calandre étant réglables par des moyens appropriés, **caractérisé en ce que** le dispositif comprend en outre une source de chaleur agissant ponctuellement (11) dirigée sur la surface du cylindre de support et montée de manière à pouvoir être déplacée axialement par rapport au cylindre de support (8).

15. Appareil selon la revendication 14, **caractérisé en ce que** la source de chaleur (11) est un dispositif de production d'un flux gazeux chaud.

16. Appareil selon la revendication 14 ou 15, **caractérisé en ce que** le rouleau de calandre (9) peut être chauffé.
